(19) Europäisches Patentamt
European Patent Office
Office européen des brevets

(11) **EP 2 829 166 B1**

## (12) EUROPÄISCHE PATENTSCHRIFT

(45) Veröffentlichungstag und Bekanntmachung des Hinweises auf die Patenterteilung:
**18.07.2018 Patentblatt 2018/29**

(21) Anmeldenummer: **13720320.4**

(22) Anmeldetag: **24.04.2013**

(51) Int Cl.:
**G06Q 10/04** *(2012.01)*    **H05K 13/08** *(2006.01)*

(86) Internationale Anmeldenummer:
**PCT/EP2013/058524**

(87) Internationale Veröffentlichungsnummer:
**WO 2014/005742 (09.01.2014 Gazette 2014/02)**

### (54) BILDUNG VON RÜSTFAMILIEN AUF BESTÜCKUNGSLINIEN

FORMATION OF EQUIPMENT FAMILIES ON FITTING LINES

FORMATION DE GROUPES D'INSTALLATION SUR DES LIGNES DE PLACEMENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.07.2012 DE 102012211810**

(43) Veröffentlichungstag der Anmeldung:
**28.01.2015 Patentblatt 2015/05**

(73) Patentinhaber: **Siemens Aktiengesellschaft**
**80333 München (DE)**

(72) Erfinder: **ROYER, Christian**
**85521 Ottobrunn (DE)**

(56) Entgegenhaltungen:
**EP-A1- 0 478 360      EP-A1- 0 478 361**

- **DINO LUZZATTO ET AL: "Cell formation in PCB assembly based on production quantitative data", EUROPEAN JOURNAL OF OPERATIONAL RESEARCH, Bd. 69, Nr. 3, 1. September 1993 (1993-09-01), Seiten 312-329, XP055085832, ISSN: 0377-2217, DOI: 10.1016/0377-2217(93)90018-I**

EP 2 829 166 B1

**Beschreibung**

Die vorliegende Erfindung betrifft ein Verfahren zur Bildung von Rüstfamilien auf Bestückungslinien. Weiterhin betrifft die Erfindung eine Steuereinrichtung für eine Fertigungs- oder Montagelinie zur Bestückung von Leiterplatten mit Bauelementen. Außerdem betrifft die Erfindung ein Computerprogrammprodukt und ein computerlesbares Medium.

Insbesondere im Bereich der Elektronikproduktion werden zu fertigende Leiterplatten bzw. Baugruppen auf SMT-Bestückungslinien durch Oberflächenmontage (surface mounted technology, SMT) hergestellt.

DE 10 2009 013 353 B3 zeigt ein Verfahren zur Rüstung einer solchen Bestückungslinie.

EP 0 478 361 A1 betrifft ein Verfahren zur Bestückung von Leiterplatten mit Bauelementen, wobei eine Produktionshäufigkeit eines Leiterplattentyps und die zur Produktion erforderlichen Bauelemente berücksichtigt werden.

Dino Luzzatto et al.: "Cell formation in PCB assembly based on production quantitative data", European Journal of Operational Research, Bd. 69, Nr. 3, 1. September 1993, S. 312-329 betrifft ein Verfahren zur Planung einer Bestückung von Leiterplatten.

EP 0 478 360 A1 betrifft ein weiteres Bestückungsverfahren, bei dem versucht wird, eine Einrichtungszeit für eine Produktionslinie zur Bestückung der Leiterplatten zu verbessern.

Eine Rüstfamilie ist bestimmt als eine Menge von Leiterplatten, die auf einer Bestückungslinie bestückt werden können, ohne die Menge der Bauteiltypen zu ändern, die an der Bestückungslinie für die Bestückung bereit gehalten sind. Bestehende Werkzeuge zur Bestimmung von Rüstfamilien erfordern häufig entweder einen manuellen Aufwand oder liefern nicht immer überzeugende Resultate. Andere bekannte Werkzeuge sind zur Verwendung an ein bestimmten Bestückungssystem gebunden.

Es ist Aufgabe der vorliegenden Erfindung, eine verbesserte Technik zur Zuordnung von Leiterplatten auf Rüstfamilien bereitzustellen.

Die Erfindung löst diese Aufgabe mittels eines Verfahrens, eines Computerprogrammprodukts und eines Bestückungssystems mit den Merkmalen der unabhängigen Ansprüche. Unteransprüche geben bevorzugte Ausführungsformen wieder.

Eine Bestückungslinie ist zur Bestückung von Leiterplatten mit elektronischen Bauteilen eingerichtet. Ein Verfahren zur Bestimmung von Rüstfamilien für die Bestückungslinie umfasst Schritte des initialen Bildens einer Anzahl Rüstfamilien mit jeweils zugeordneten Leiterplatten, des Wählens einer der Rüstfamilien und des Verteilens der Leiterplatten der gewählten Rüstfamilie auf die anderen Rüstfamilien mittels ganzzahliger linearer Programmierung.

Dabei ist eine Rüstfamilie bestimmt als eine Menge von Leiterplatten, die auf einer Bestückungslinie bestückt werden können, ohne die Menge der Bauteiltypen zu ändern, die an der Bestückungslinie für die Bestückung bereit gehalten sind. Die Menge der an der Bestückungslinie bereit gehaltenen Bauteiltypen wird auch Rüstung genannt. Es wird üblicherweise davon ausgegangen, dass stets ausreichend viele Bauteile jedes Bauteiltyps an der Bestückungslinie bereit gehalten sind.

Durch das Verfahren kann eine Anzahl Rüstfamilien der Bestückungslinie bzw. des Bestückungssystems verringert werden. Dadurch können Rüstwechsel seltener gestaltet werden, so dass durch Umrüstungen bedingte Produktionsausfälle vermieden werden können. Außerdem können die bestimmten Rüstfamilien bestehende Vorratseinrichtungen an der Bestückungslinie, insbesondere einen Wechseltisch oder eine Zuführungseinrichtung, verbessert ausnutzen. Eine Anzahl weiterer Vorratseinrichtungen, die für die weiteren Rüstfamilien der Bestückungslinie bereit gehalten werden müssen, kann reduziert sein, wodurch beträchtliche Kosten eingespart werden können. Das Verfahren kann mit allen üblichen Bestückungslinien verwendet werden.

In einer bevorzugten Ausführungsform wird diejenige Rüstfamilie zur Verteilung auf andere Rüstfamilien ausgewählt, deren zugeordnete Leiterplatten die geringste Anzahl Bauteiltypen aufweist. Jeder Bauteiltyp umfasst eine Vielzahl Bauteile, die bezüglich eines Bestückungsvorgangs auf dem Bestückungssystem nicht voneinander unterscheidbar sind. Die Anzahl von Bauteiltypen einer Leiterplatte oder einer Rüstfamilie wird auch deren Bauteilevarianz genannt. Die Anzahl Bauteiltypen kann leicht bestimmbar sein und die Wahrscheinlichkeit, die solchermaßen ausgewählte Rüstfamilie auflösen zu können, kann hoch sein. Das Verfahren kann daher rasch konvergieren und zu einer geringen Anzahl von bestimmten Rüstfamilien führen. In anderen Ausführungsformen können die zu verteilenden Rüstfamilien auch auf der Basis anderer Kriterien bestimmt werden, beispielsweise zufällig.

Bevorzugterweise werden so lange Rüstfamilien gewählt und verteilt, bis keine Rüstfamilie mehr auf die anderen Rüstfamilien aufteilbar ist. Durch die Verwendung eines iterativen Verfahrens kann das Problem der Zuordnung von Leiterplatten zu Rüstfamilien auf ein gemischt ganzzahliges Programm (Mixed Integer Programm, MIP) zurückgeführt werden, für welches Standard-Solver existieren, beispielsweise Ilog oder Xpress. In iterativer Weise kann ein solcher Solver dazu verwendet werden, eine bereits erarbeitete Zwischenlösung von bestimmten Rüstfamilien zu verbessern. Mit jeder Iteration kann die Anzahl der Rüstfamilien um wenigstens eins verringert werden. Mit zu erwartender zukünftig gesteigerter Leistungsfähigkeit der Standard-Solver kann auch eine Bestimmungsgeschwindigkeit des Verfahrens weiter ansteigen. Erfindungsgemäß umfasst das Verteilen Schritte des Auswählens wenigstens einer Leiterplatte einer anderen als der zu verteilenden Rüstfamilie, des Verhinderns einer Änderung der bestehenden Zuordnung der ausgewählten Leiterplatten zu einer anderen Rüstfamilie und des Lösens des verbleibenden Problems der Bildung von Rüstfamilien mittels ganzzahliger linearer Programmierung.

Dieser Ansatz kann insbesondere für größere Problemstellungen mit zahlreichen Leiterplatten von Vorteil sein. Durch das Verhindern einer Veränderung der Zuordnung der ausgewählten Leiterplatten zu einer anderen Rüstfamilie kann das zu lösende IP-Problem verkleinert werden, so dass eine Lösung beschleunigt bestimmt werden kann. Diese Verkleinerung kann iterativ erfolgen, bis das Problem ausreichend klein ist, um schnell und dabei mit ausreichender Qualität mittels eines MIP gelöst zu werden. Ein Abbruch des MIP kann erfolgen, wenn alle Leiterplatten aus der ausgewählten Rüstfamilie auf andere Rüstfamilien aufgeteilt sind oder ein Zeitlimit erreicht wurde.

In einer Ausführungsform wird die Leiterplatte, deren Neuzuordnung verhindert wird, zufällig ausgewählt. In einer anderen Ausführungsform kann auch eine gezielte Auswahl der Leiterplatte erfolgen, beispielsweise auf der Basis der auf ihr zu bestückenden Bauteile oder eines Spurverbrauchs dieser Bauteile. Ein Spurverbrauch ist gegeben als die Anzahl Spuren einer Vorratseinrichtung einer Bestückungslinie, die zur Bereitstellung des Bauteils erforderlich ist. Übliche Spuren sind 8 mm breit und ein Bauteil kann eine oder mehrere Spuren belegen.

Das initiale Bilden einer Rüstfamilie kann vorzugsweise mittels eines Greedy-Verfahrens bezüglich eines Spurverbrauchs erfolgen. In einer Ausführungsform wird hierzu eine Leiterplatte ausgewählt, deren zugeordnete Bauteiltypen insgesamt den größten Spurverbrauch aufweisen und die ausgewählte Leiterplatte wird einer neue erstellten Rüstfamilie zugeordnet. Die verbleibenden Leiterplatten werden auf die Schnittmengen der auf ihnen zu bestückenden Bauteiltypen mit den Bauteiltypen der zuvor erstellten Rüstfamilie untersucht. Dabei wird diejenige Leiterplatte bestimmt, von der die Bauteile der Schnittmenge den größten Spurverbrauch aufweisen. Falls die ausgewählte Leiterplatte noch in die Rüstfamilie passt, wird sie der neuen Rüstfamilie zugeordnet. Die Leiterplatte kann beispielsweise dann in die Rüstfamilie passen, wenn die Bauteiltypen der resultierenden Rüstfamilie noch gleichzeitig durch Vorratseinrichtungen der Bestückungslinie bereit gehalten werden können.

Durch die beschriebene Vorgehensweise kann auf rasche und effiziente Weise eine initiale Menge von Rüstfamilien gefunden werden, die eine Startlösung darstellen, die in iterativen Durchläufen des eingangs beschriebenen Verfahrens rasch zu einer hochwertigen Lösung verfeinert werden kann. Die bestimmte Startlösung kann durch den beschriebenen "Greedy"-Ansatz bereits eine gute Qualität aufweisen, so dass im anschließenden Verfahren unter Umständen weniger Aufwand zur Optimierung betrieben werden muss.

Bevorzugter Weise werden beim beschriebenen initialen Bilden der Rüstfamilie iterativ weitere Leiterplatten ausgewählt und der Rüstfamilie zugeordnet, bis keine weitere Leiterplatte mehr in die Rüstfamilie passt.

In einer Ausführungsform werden so lange neue Rüstfamilien gebildet und den gebildeten Rüstfamilien Leiterplatten zugeordnet, bis alle zu bestückenden Leiterplatten einer Rüstfamilie zugeordnet sind. Das initiale Bilden der Anzahl Rüstfamilien kann auf diese Weise rasch und effizient durchführbar sein.

Ein Computerprogrammprodukt umfasst Programmcodemittel zur Durchführung des beschriebenen Verfahrens, wenn es auf einer Ausführungseinrichtung abläuft oder auf einem computerlesbaren Medium gespeichert ist. Das Computerprogrammprodukt kann in einer üblichen Programmiersprache (z.B. C++, Java) erstellt sein. Die Verarbeitungseinrichtung kann einen marktüblichen Computer oder Server mit entsprechenden Eingabe-, Ausgabe- und Speichermitteln umfassen.

Eine Steuereinrichtung zur Bestimmung von Rüstfamilien für eine Bestückungslinie zur Bestückung von Leiterplatten mit elektronischen Bauteilen ist zur Durchführung des oben beschriebenen Verfahrens eingerichtet.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:

Fig. 1    ein Bestückungssystem;

Fig. 2    eine Veranschaulichung von Rüstfamilien am Bestückungssystem von Fig. 1; und

Fig. 3    eine Veranschaulichung einer Zuordnung von Rüstfamilien auf Bestückungslinien am Bestückungssystem von Fig. 1; und

Fig. 4    ein Ablaufdiagramm eines Optimierungsverfahrens am Bestückungssystem von Fig. 1

darstellt.

Die Lineare Optimierung ist eines der Hauptverfahren auf dem Gebiet mathematische Optimierung und befasst sich mit der Optimierung linearer Zielfunktionen über einer Menge, die durch lineare Gleichungen und Ungleichungen eingeschränkt ist. Die Lineare Optimierung ist die Grundlage der Lösungsverfahren der (gemischt) ganzzahligen Linearen Optimierung.

Vorteile der Linearen Optimierung:

- Globaler Optimierungsansatz.
- Leicht erweiterbar.
- Sehr gute kommerzielle Standard-Solver (SCIP, CPLEX, Ilog, Xpress), die in der Praxis weit verbreitet und bewährt sind.
- Für eine ermittelte Lösung ist bekannt, wie weit sie maximal von der optimalen Lösung entfernt ist (Gap).

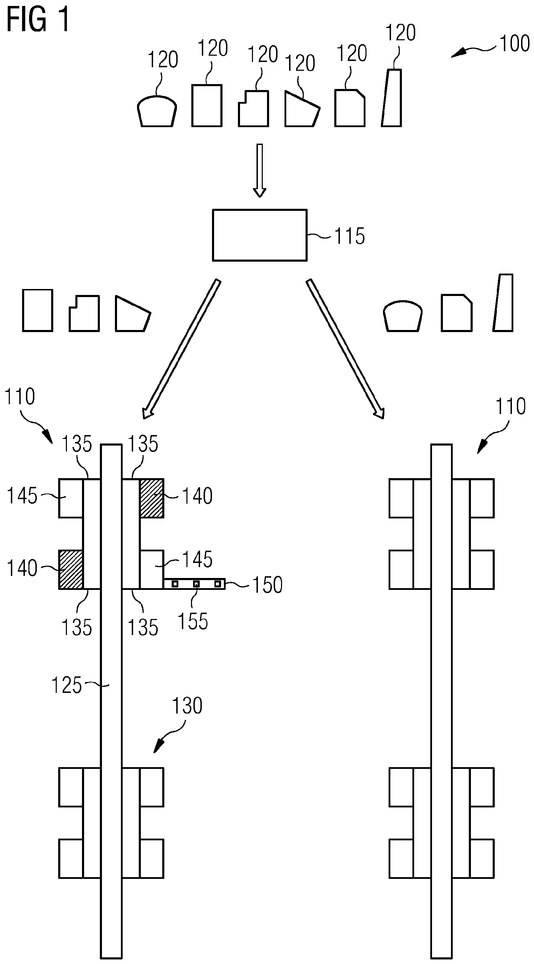

Figur 1 zeigt ein Bestückungssystem 100. Das Bestückungssystem 100 umfasst mehrere Bestückungslinien 110 und eine Steuereinrichtung 115 zur Zuordnung von Leiterplatten 120 an die Bestückungslinien 110. Jede Bestückungslinie 110 umfasst üblicherweise ein Transportsystem 125 und ein oder mehrere Bestückungsautomaten 130. Jeder Bestückungsautomat 130 umfasst einen oder mehrere Bestückungsköpfe 135, die jeweils dazu eingerichtet sind, von einem konstanten Tisch 140 oder einem variablen Tisch 145 Bauelemente aufzunehmen und an einer vorbestimmten Position auf der Leiterplatte 120 zu positionieren, die sich auf dem Transportsystem 125 befindet.

Während des Bestückungsvorgangs besteht die Leiterplatte 120 bezüglich des Bestückungsautomaten 130 üblicherweise still. Die Tische 140, 145 umfassen jeweils eine Vielzahl Zuführungseinrichtungen 150, von denen nur eine exemplarisch dargestellt ist. Jede Zuführungseinrichtung 150 hält einen Vorrat von Bauteilen 155 eines vorbestimmten Typs bereit. Zwar kann jede Zuführungseinrichtung 150 zur Bereithaltung unterschiedlicher Bauteile 155 konfiguriert werden und unterschiedliche Zuführungseinrichtungen 150 an einem Tisch 140, 145 angebracht werden, jedoch werden die Tische 140, 145 aus Geschwindigkeitsgründen üblicherweise komplett ausgetauscht, wenn ein Bestückungsautomat 130 mit Bauteilen 155 versorgt werden muss, die nicht auf einem der angebrachten Tische 140, 145 vorgehalten sind.

Da ein solcher Wechsel üblicherweise mit einem Produktionsstillstand verbunden ist, wird angestrebt, die Zahl der zu wechselnden Tische 140, 145 gering zu halten. Wird ein Tisch während eines Umrüstvorgangs nicht ausgetauscht, so wird er als konstanter Tisch 140 bezeichnet, ansonsten als variabler Tisch 145. Funktionale Unterschiede zwischen einem konstanten Tisch 140 und einem variablen Tisch 145 bestehen ansonsten nicht.

Die Leiterplatte 120 ist mit einer Anzahl unterschiedlicher Bauteile 155 zu bestücken. Um ein häufiges Wechseln von variablen Tischen 145 zu minimieren und idealerweise eine Zahl konstanter Tische 140 zu maximieren, ist die Steuereinrichtung 115 dazu eingerichtet, die Zuordnung einer Leiterplatte 120 an eine der Bestückungslinien 110 zu optimieren. Dabei müssen üblicherweise spezifische Eigenschaften jeder Bestückungslinie 110 bzw. jedes Bestückungsautomaten 130 genauso berücksichtigt werden, wie Eigenschaften der Leiterplatten 120 bzw. der auf ihnen zu bestückenden Bauteile 155.

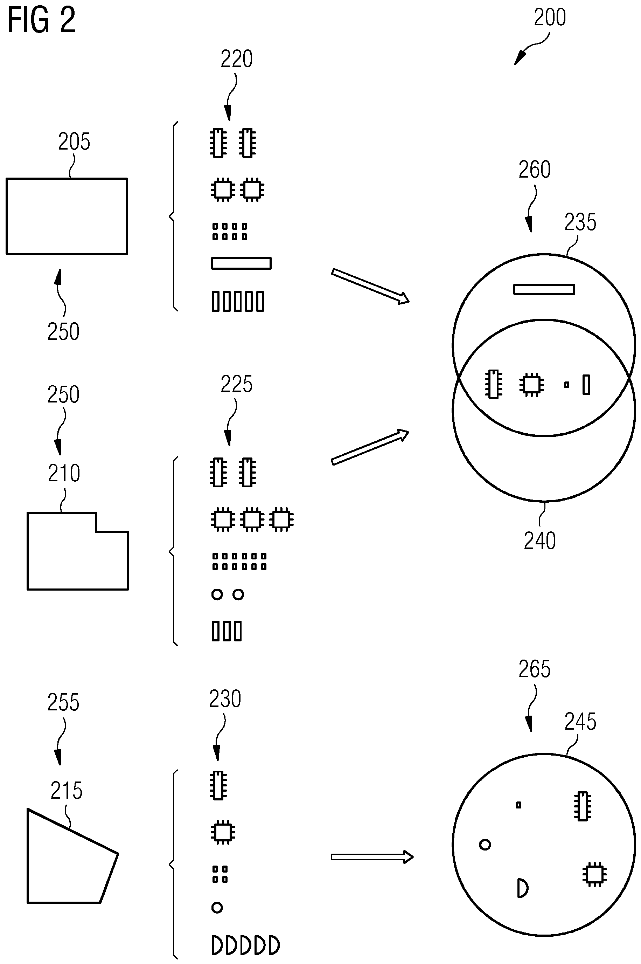

Figur 2 zeigt eine Veranschaulichung 200 von Rüstfamilien, auch "Cluster" genannt. Betrachtet werden eine erste Leiterplatte 205, eine zweite Leiterplatte 210 und eine dritte Leiterplatte 215, die jeweils einer der Leiterplatten 120 im Bestückungssystem 100 aus Figur 1 entsprechen. Auf der ersten Leiterplatte 205 ist eine erste Menge 220 von Bauteilen 155, auf der zweiten Leiterplatte 210 eine zweite Menge 225 von Bauteilen 155 und auf der dritten Leiterplatte 215 eine dritte Menge 230 von Bauteilen 155 zu bestücken. In exemplarischer Weise umfassen die Mengen 220 bis 230 jeweils fünf unterschiedliche Bauteiltypen, von denen jeweils Bauteile 155 in unterschiedlichen Anzahlen verwendet werden. Den Mengen 220 bis 230 von Bauteilen 155 sind daher Mengen 235 bis 245 von Bauteiltypen zugeordnet. In den Mengen 235 bis 245 findet sich jedes der unterschiedlichen Bauteile 155 der entsprechenden Menge 220 bis 230 nur einmal wieder.

Eine Rüstfamilie umfasst diejenigen Leiterplatten 120, die zur Bestückung auf einer Bestückungslinie 100 zugeordnet sind. Im Beispiel von Figur 2 sind die Leiterplatten 205 und 210 der gleichen Bestückungslinie 110 zugeordnet und bilden eine erste Rüstfamilie 250. Die erste Rüstfamilie 250 erfordert daher eine erste Rüstung 260 mit Bauteiltypen der Vereinigungsmenge der Mengen 235 und 240, die den Leiterplatten 205 bzw. 210 zugeordnet sind. Im dargestellten Beispiel umfasst die erste Rüstung 260 sechs Bauteiltypen. Unter Bereitstellung der Bauteiltypen der ersten Rüstung 260 lassen sich die Leiterplatten 205 und 210 der ersten Rüstfamilie 250 ohne Umrüstung auf der Bestückungslinie 110 bestücken.

Die dritte Leiterplatte 215 ist einer anderen Bestückungslinie 110 zugeordnet und bildet allein eine zweite Rüstfamilie 255. Eine der zweiten Rüstfamilie 255 zugeordnete zweite Rüstung 265 umfasst fünf Bauteiltypen.

Würde die dritte Leiterplatte 215 der gleichen Rüstfamilie wie die Leiterplatte 205 und 210 zugeordnet, so enthielte die der resultierenden Rüstfamilie zugeordnete Rüstung die Vereinigungsmenge der Bauelementtypen der Mengen 235 bis 245, im vorliegenden Beispiel also sieben Bauelementtypen. Weist die Bestückungslinie 110 nur Aufnahmekapazitäten für sechs unterschiedliche Bauteile 155 auf, so kann die solchermaßen gebildete Rüstfamilie der Bestückungslinie 110 nicht zugeordnet werden bzw. die dritte Leiterplatte 215 passt nicht mehr in die der Bestückungslinie 110 zugeordnete Rüstfamilie.

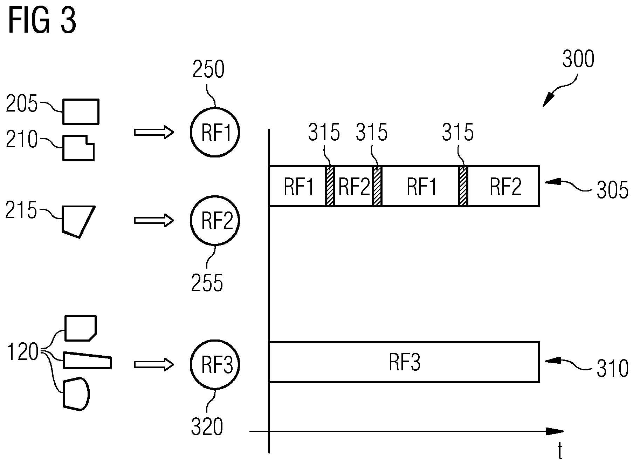

Figur 3 zeigt eine Veranschaulichung 300 einer Zuordnung von Rüstfamilien 250, 255 an Bestückungslinien 110 am Bestückungssystem 100 von Figur 1. Die Darstellung lehnt sich an das in Figur 2 gegebene Beispiel an.

Einer ersten Bestückungslinie 305 sind die erste Rüstfamilie 250 und die zweite Rüstfamilie 255 aus Figur 2 zugeordnet. Die Rüstfamilien 250 und 255 werden abwechselnd auf der Bestückungslinie 110 gerüstet, wobei bei jeder Änderung ein Rüstwechsel 315 anfällt.

Einer zweiten Bestückungslinie 310 ist eine dritte Rüstfamilie 320 zugeordnet. Die dritte Rüstfamilie 320 ist der zweiten Bestückungslinie 310 fest zugeordnet, eine Umrüstung der zweiten Bestückungslinie 310 findet im gezeigten Beispiel nicht statt.

Es wird versucht, die Leiterplatten 120 derart an Rüstfamilien 250, 255, 320 zuzuweisen, dass jeweils eine möglichst große Vielzahl unterschiedlicher Leiterplatten 120 bestückbar ist. Üblicherweise sind einer Bestückungslinie 110 jedoch mehr Leiterplatten 120 zugeordnet als von einer Rüstfamilie umfasst sein können, da an der Bestückungslinie 110 nicht beliebig viele Bauteiltypen bereit gehalten werden können. Die Bestückungslinie 110 wird daher gelegentlich einem Rüstwechsel unterzogen, bei dem die Rüstung für eine erste Rüstfamilie gegen die Rüstung für eine zweite Rüstfamilie gewechselt wird. Je seltener diese Rüstwechsel sind und je weniger Bauteiltypen bei einem Rüstwechsel gewechselt werden müssen, desto kostengünstiger kann das Bestückungssystem betrieben werden.

Um eine Häufigkeit von Umrüstungen der Bestückungslinie 305 möglichst gering zu halten, wird versucht, die Anzahl von Rüstfamilien 250, 255 der Bestückungslinie 110 möglichst zu verkleinern. In einer Ausführungsform wird auch versucht, die Rüstfamilien 250, 255 so zu bilden, dass bei einem Rüstwechsel 315 nicht zu viele Bauteiltypen umzurüsten sind, um die Anzahl variabler Tische 145 an der Bestückungslinie 110 zu verringern und die der konstanten Tische 140 zu erhöhen. Bei der Bildung von Rüstfamilien 250, 255 kann ferner zu beachten sein, dass aus technischen Gründen unter Umständen nicht jedes Bauteil 155 einer Leiterplatte 120 auf jeder Bestückungslinie 110 verarbeitet werden kann.

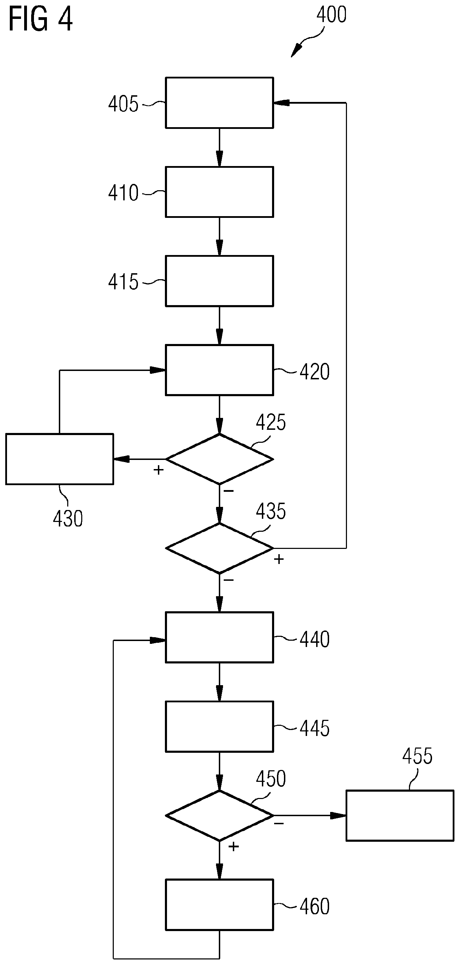

Die Bildung von Rüstfamilien 250, 255, 320 für die einzelnen Bestückungslinien 305, 310 soll im Folgenden mit Bezug auf die Figur 4 genauer erläutert werden.

Figur 4 zeigt ein Ablaufdiagramm eines Verfahrens 400 zur optimierten Zuordnung von Leiterplatten 120 zu Rüstfamilien 250, 255, 320. In einem ersten Abschnitt des Verfahrens 400 wird in Schritten 405 bis 435 ein Greedy-Verfahren zum initialen Bilden einer Anzahl Rüstfamilien 250, 255, 320 durchgeführt. Es sind auch andere Teilverfahren zur Bildung der Rüstfamilien 250, 255, 320 möglich. Die bestimmten Rüstfamilien 250, 255, 320 dienen als Startlösung für einen zweiten Abschnitt des Verfahrens 400, welches in Schritten 440 bis 460 die Anzahl der Rüstfamilien 250, 255, 320 verringert.

Schritt 405: Zuerst wird in einem ersten Schritt 405 eine Rüstfamilie 250, 255, 320 erzeugt.

Schritt 410: Anschließend wird unter den vorhandenen, noch zuzuordnenden Leiterplatten 120 diejenige ausgesucht, die den größten Spurverbrauch aufweist. Die Bauteile 155 jeder Leiterplatte 120 erfordern jeweils eine oder mehrere Spuren, in denen die konstanten Tische 140 und die variablen Tische 145 sowie die Zuführungseinrichtung 155 organisiert sind. Die Bauteile 155 eines Bauteiltyps können unterschiedlich große Spurverbräuche aufweisen.

Schritt 415: Danach wird die bestimmte Leiterplatte 120 der im Schritt 405 bestimmten neuen Rüstfamilie 250, 255, 320 zugeordnet.

Schritt 420: Dann wird eine weitere Leiterplatte 120 ausgewählt. Für die ausgewählte Leiterplatte 120 gilt, dass der Spurverbrauch der Bauteiltypen, die in der Schnittmenge der Bauteiltypen der ausgewählten Leiterplatte 120 mit denen der neuen Rüstfamilie liegen, am größten ist.

In einer anderen Ausführungsform wird die diejenige Leiterplatte 120 ausgewählt, welche, wenn sie der im Schritt 405 erzeugte Rüstfamilie 250, 255, 320 zugeordnet wird, deren Spurverbrauch am wenigsten vergrößert.

Schritt 425: Anschließend wird überprüft, ob die ausgewählte weitere Leiterplatte in die Rüstfamilie 250, 255, 320 passt. Dies ist dann der Fall, wenn nach dem Zuordnen der weiteren Leiterplatte zur Rüstfamilie 250, 255, 320 die Bauteiltypen der Rüstfamilie 250, 255, 320 vollständig in die Zuführeinrichtungen 140, 145, 150 der Bestückungslinie 110 geladen werden können.

Schritt 430: Verläuft der genannte Test positiv, so wird in einem Schritt 430 die weitere Leiterplatte 120 der Rüstfamilie 250, 255, 320 zugeordnet und das Verfahren 500 fährt fort mit dem oben beschriebenen Schritt 420.

Schritt 435: Verläuft der genannte Test hingegen negativ, so wird in einem Schritt 435 überprüft, ob weitere Leiterplatten 120 vorhanden sind, die noch keiner Rüstfamilie 250, 255, 320 zugeordnet sind. Ist dies der Fall, so verzweigt das Verfahren 400 zurück zum Schritt 405, um eine neue Rüstfamilie 250, 255, 320 zu erzeugen.

Anschließend wird die bestimmte Startlösung, die alle bis zu diesem Punkt bestimmten Rüstfamilien 250, 255, 320 umfasst, iterativ verbessert.

Schritt 440: Dazu wird zunächst aus den bestimmten Rüstfamilien 250, 255, 320 eine ausgewählt, um die ihr zugeordneten Leiterplatten 120 auf die anderen Rüstfamilien 250, 255, 320 zu verteilen. In einer bevorzugten Ausführungsform wird diejenige Rüstfamilie 250, 255, 320 ausgewählt, deren zugeordneten Leiterplatten 120 die geringste Anzahl Bauteiltypen aufweist. Alternativ kann auch ein anderes Auswahlkriterium verwendet werden, beispielsweise welche Rüstfamilie 250, 255, 320 den geringsten Spurverbrauch aufweist.

Schritt 445: Anschließend wird mittels ganzzahliger linearer Programmierung (MIP) auf der Basis der geltenden Lösung, also allen bestimmten Rüstfamilien 250, 255, 320, versucht, die Leiterplatten 120 der im Schritt 440 ausgewählten Rüstfamilie 250, 255, 320 auf die anderen Rüstfamilien 250, 255, 320 zu verteilen. Dieser Schritt kann mittels eines Standard-Solvers durchgeführt werden. Die ganzzahlige lineare Programmierung kann auch noch zusätzliche Restriktionen berücksichtigen. Beispielsweise können bestimmte Bauelemente 155 nur an vorbestimmten Tischen 140, 145 bereitgehalten werden, etwa aus Gründen ihrer Größe oder Beschaffenheit. Ferner kann ein maximaler Füllgrad der Bestückungslinie 110 mit Bauteilen 155 gegeben sein. Außerdem kann eine Teilmenge der Leiterplatten 120 stets derselben Rüstfamilie 250, 255, 320 zugeordnet werden. Dies ist beispielsweise sinnvoll bei einer Bestückung einer Oberseite und einer Unterseite derselben Leiterplatte 120. Schließlich können Leiterplatten 120 identifiziert werden, die unterschiedlichen Rüstfamilien 250, 255, 320 zugeordnet werden müssen.

Schritt 450: Dann wird überprüft, ob eine Verteilung von Leiterplatten 120 an Rüstfamilien 250, 255, 320 gefunden werden konnte, in welcher die zuvor ausgewählte Rüstfamilie 250, 255, 320 leer ist.

Schritt 455: Ist dies nicht der Fall, so terminiert das Verfahren 400 in einem Schritt 455.

In einer Variante kann die Bestimmung der Lösung mittels ganzzahliger linearer Programmierung in Schritt 445 auch iterativ gestaltet sein. Dabei werden in der vorliegenden Lösung einige Leiterplatten 120 in ihren Zuordnungen zu einer Rüstfamilie 250, 255, 320 fixiert, während andere in ihrer Zuordnung variiert werden können. Dann wird die ganzzahlige lineare Programmierung auf der Basis dieser Lösung durchgeführt, wodurch eine oder mehrere neue Lösungen bestimmt werden. Zu jeder bestimmten Lösung wird ein Kriterium gebildet, das auf die Qualität der Lösung hinweist. Dann werden solche Lösungen verworfen, deren Kriterium auf eine nicht ausreichende Qualität hinweist. Die übrigen Lösungen können in einem oder mehreren weiteren Durchläufen der ganzzahligen linearen Programmierung weiter verbessert werden. Ein Abbruch dieser Iteration kann erfolgen, wenn eine Lösung mit einer vorbestimmten Qualität gefunden oder eine vorbestimmte Bestimmungszeit abgelaufen ist.

Schritt 460: Konnten im Schritt 455 die Leiterplatten 120 wenigstens einer Rüstfamilie 250, 255, 320 auf andere Rüstfamilien 250, 255, 320 verteilt werden, so werden alle leeren Rüstfamilien 250, 255, 320 aus der bestehenden Lösung bestimmt und entfernt. Dies ist bei erfolgreicher Verteilung der ausgewählten Rüstfamilie 250, 255, 320 mindestens eine, können aber auch mehrere sein. Anschließend kehrt das Verfahren 400 zurück zu Schritt 440, um erneut zu durchlaufen.

Nach dieser Festlegung können weitere Leiterplatten 120 iterativ ihrer aktuellen Rüstfamilie 250, 255, 320 fest zugeordnet werden, um das Problem für eine ganzzahlige lineare Programmierung weiter zu verkleinern. Ein Abbruch dieser Iteration kann erfolgen, wenn das resultierende Problem ausreichend klein ist, um eine sinnvolle Bearbeitung durch den Standard-Solver zu ermöglichen. Nachdem ausreichend viele Leiterplatten 120 festgelegt wurden, kann der oben beschriebene 445 durchgeführt werden.

Mathematischer Hintergrund

Durch den Einsatz von exakten mathematischen Verfahren lassen sich deutlich bessere Lösungen erzielen als mit bisher in der Praxis verwendeten Heuristiken. Im weiteren Unterschied dazu können mit diesen Verfahren auch gute Produktionszeiten erreicht werden.

**Indices**

| R | Menge der Leiterplatten 120 |
|---|---|
| C | Menge der Bauelementtypen 155 |
| Cl | Menge der Rüstfamilien 250, 255, 320 |
| $R_c$ | Menge der Leiterplatten mit Bauelementtyp c |

**Parameter**

| $Time_{r,l}$ | Gesamtproduktionszeit für Leiterplatte r auf Linie $l$ |
|---|---|
| $TimeLimit_l$ | Produktionszeitschranke auf Linie $l$ |

**Binär-Variablen**

| $Assign_{r,cl}$ | Zuordnung Leiterplatte r zu Rüstfamilie $cl$ |
|---|---|
| $Setup_{c,cl}$ | Verwendung eines Bauelements c in Rüstfamilie $cl$ |

**IP Formulierung**

$$\text{minimize} \sum_{c \in C} Setup_{c,cl'}$$

wobei cl' die zu Rüstfamilie ist, die auf andere Rüstfamilien zu verteilen ist

s.t.:

$$\sum_{cl \in Cl} Assign_{r,cl} = 1 \qquad\qquad r \in R$$

$$\sum_{r \in R_c} Assign_{r,cl} \leq |R_c| Setup_{c,cl} \qquad\qquad c \in C, cl \in Cl$$

$$\sum_{c \in C_c} Width_c\, Setup_{c,cl} \leq Cap_{cl} \qquad\qquad cl \in Cl$$

$$Setup_{c,cl} \in \{0,1\} \qquad\qquad c \in C, cl \in Cl$$

$$Assign_{r,cl} = \{0,1\} \qquad\qquad r \in R, cl \in Cl$$

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Verfahren (300) zur Bestückung von Leiterplatten (120) mit elektronischen Bauteilen (155) mittels einer Bestückungslinie (110), wobei das Verfahren folgende Schritte umfasst:

   - initiales Bilden (405,435) einer Anzahl Rüstfamilien (250, 255, 320) mit jeweils zugeordneten Leiterplatten (120),
   - wobei eine Rüstfamilie bestimmt ist als eine Menge von Leiterplatten (120), die auf einer Bestückungslinie (110) bestückt werden können, ohne die Menge der Bauteiltypen zu ändern, die an der Bestückungslinie (110) für die Bestückung bereit gehalten sind, wobei eine Leiterplatte dann noch in eine Rüstfamilie aufgenommen werden kann, wenn die Bauteiltypen der resultierenden Rüstfamilie noch gleichzeitig durch Vorratseinrichtungen der Bestückungslinie bereit gehalten werden können,

   und **gekennzeichnet durch** die folgenden Schritte:

   - Wählen (440) einer der Rüstfamilien (250, 255, 320);
   - Verteilen (445) der Leiterplatten der gewählten Rüstfamilie (250, 255, 320) auf die anderen Rüstfamilien (250, 255, 320) mittels ganzzahliger Linearer Programmierung und
   - Bestücken der Leiterplatten (120) auf den jeweils zugeordneten Bestückungslinien (110),
   - wobei das Verteilen folgende Schritte umfasst:

- Auswählen (445) wenigstens einer Leiterplatte (120) einer anderen als der zu verteilenden Rüstfamilie (250, 255, 320);
- Verhindern (445) einer Änderung der bestehenden Zuordnung der ausgewählten Leiterplatte zu einer anderen Rüstfamilie (250, 255, 320), und
- Lösen (445) des verbleibenden Problems mittels ganzzahliger Linearer Programmierung.

2. Verfahren (300) nach Anspruch 1, wobei diejenige Rüstfamilie (250, 255, 320) gewählt wird, deren zugeordnete Leiterplatten (120) die geringste Anzahl Bauteiltypen aufweist.

3. Verfahren (300) nach Anspruch 1 oder 2, wobei so lange Rüstfamilien (250, 255, 320) gewählt und verteilt werden, bis keine Rüstfamilie (250, 255, 320) mehr auf die anderen Rüstfamilien (250, 255, 320) aufteilbar ist.

4. Verfahren (300) nach Anspruch einem der vorangehenden Ansprüche, wobei die Leiterplatte (120) zufällig ausgewählt wird.

5. Verfahren (300) nach einem der vorangehenden Ansprüche, wobei das initiale Bilden einer Rüstfamilie (250, 255, 320) folgende Schritte umfasst:

Auswählen (410) einer Leiterplatte (120), deren zugeordnete Bauteiltypen den größten Spurverbrauch aufweisen;
Zuordnen (415) der ausgewählten Leiterplatte (120) an eine neue Rüstfamilie (250, 255, 320);
Auswählen (420) einer der verbleibenden Leiterplatten (120), für welche ein Spurverbrauch der Schnittmenge ihrer Bauteiltypen mit der Menge der Bauteiltypen der neuen Rüstfamilie (250, 255, 320) am größten ist, und
Zuordnen (430) der ausgewählten Leiterplatte (120) an die neue Rüstfamilie (250, 255, 320), falls (425) die Leiterplatte (120) noch in die Rüstfamilie (250, 255, 320) passt.

6. Verfahren (300) nach Anspruch 5, wobei so lange weitere Leiterplatten (120) ausgewählt und zugeordnet werden, bis keine weitere Leiterplatte (120) mehr in die Rüstfamilie (250, 255, 320) passt.

7. Verfahren (300) nach den Ansprüchen 5 oder 6, wobei so lange neue Rüstfamilien (250, 255, 320) gebildet und ihnen Leiterplatten (120) zugeordnet werden, bis alle zu bestückenden Leiterplatten (120) einer Rüstfamilie (250, 255, 320) zugeordnet sind.

8. Computerprogrammprodukt mit Programmcodemitteln zur Durchführung des Verfahrens (300) nach einem der vorangehenden Ansprüche, wenn das Computerprogrammprodukt auf einer Ausführungseinrichtung (115) abläuft oder auf einem computerlesbaren Medium gespeichert ist.

9. Steuereinrichtung (115) zur Steuerung der Bestückung von Leiterplatten (120) mit elektronischen Bauteilen (155) mittels einer eine Bestückungslinie (110), wobei die Steuereinrichtung (115) dazu eingerichtet ist:

- eine Anzahl Rüstfamilien (250, 255, 320) mit jeweils zugeordneten Leiterplatten (120) initial zu bilden,
- wobei eine Rüstfamilie bestimmt ist als eine Menge von Leiterplatten (120), die auf einer Bestückungslinie (110) bestückt werden können, ohne die Menge der Bauteiltypen zu ändern, die an der Bestückungslinie (110) für die Bestückung bereit gehalten sind, wobei eine Leiterplatte dann noch in eine Rüstfamilie aufgenommen werden kann, wenn die Bauteiltypen der resultierenden Rüstfamilie noch gleichzeitig durch Vorratseinrichtungen der Bestückungslinie bereit gehalten werden können,

gekennzeichnet dadurch, dass die Steuereinrichtung weiter eingerichtet ist:

- eine der Rüstfamilien (250, 255, 320) auszuwählen,
- die Leiterplatten (120) der gewählten Rüstfamilie (250, 255, 320) auf die anderen Rüstfamilien (250, 255, 320) mittels ganzzahliger Linearer Programmierung zu verteilen und
- die Leiterplatten (120) auf den jeweils zugeordneten Bestückungslinien (110) zu bestücken,
- wobei das Verteilen folgende Schritte umfasst:

- Auswählen (445) wenigstens einer Leiterplatte (120) einer anderen als der zu verteilenden Rüstfamilie (250, 255, 320);
- Verhindern (445) einer Änderung der bestehenden Zuordnung der ausgewählten Leiterplatte zu einer anderen Rüstfamilie (250, 255, 320), und

- Lösen (445) des verbleibenden Problems mittels ganzzahliger Linearer Programmierung.

**Claims**

1. Method (300) for populating circuit boards (120) with electronic components (155) by means of a fitting line (110), wherein the method comprises the following steps:

   - initial formation (405, 435) of a number of equipment families (250, 255, 320) having in each case assigned circuit boards (120),
   - wherein an equipment family is defined as a number of circuit boards (120) that can be populated on one fitting line (110) without changing the number of component types that are held ready at the fitting line (110) for populating, wherein a circuit board can still be taken into an equipment family if the component types of the resulting equipment family can still simultaneously be held ready by supply apparatuses of the fitting line,

   and **characterized by** the following steps:

   - selection (440) of one of the equipment families (250, 255, 320);
   - distribution (445) of the circuit boards of the selected equipment family (250, 255, 320) across the other equipment families (250, 255, 320) by means of integer linear programming and
   - population of the circuit boards (120) on the repectively assigned fitting lines (110),
   - wherein the distribution comprises the following steps:

     - selection (445) of at least one circuit board (120) of an equipment family (250, 255, 320) other than the one to be distributed;
     - prevention (445) of a change to the existing assignment of the selected circuit board to another equipment family (250, 255, 320), and
     - solution (445) of the remaining problem by means of integer linear programming.

2. Method (300) according to Claim 1, wherein that equipment family (250, 255, 320) whose assigned circuit boards (120) exhibit the smallest number of component types is selected.

3. Method (300) according to Claim 1 or 2, wherein equipment families (250, 255, 320) are selected and distributed until no further equipment family (250, 255, 320) can any longer be distributed across the other equipment families (250, 255, 320).

4. Method (300) according to one of the preceding claims, wherein the circuit board (120) is selected at random.

5. Method (300) according to one of the preceding claims, wherein the initial formation of an equipment family (250, 255, 320) comprises the following steps:

   selection (410) of a circuit board (120) whose assigned component types exhibit the largest track usage;
   assignment (415) of the selected circuit board (120) to a new equipment family (250, 255, 320);
   selection (420) of one of the remaining circuit boards (120) for which a track usage of the cut set of its component types with the set of the component types of the new equipment family (250, 255, 320) is largest, and assignment (430) of the selected circuit board (120) to the new equipment family (250, 255, 320) if (425) the circuit board (120) still fits into the equipment family (250, 255, 320) .

6. Method (300) according to Claim 5, wherein further circuit boards (120) are selected and assigned until no more circuit boards (120) fit any longer into the equipment family (250, 255, 320).

7. Method (300) according to Claim 5 or 6, wherein new equipment families (250, 255, 320) are formed and circuit boards (120) are assigned to them until all the circuit boards (120) that are to be populated are assigned to an equipment family (250, 255, 320).

8. Computer program product with program code means for performing the method (300) according to one of the preceding claims, when the computer program product runs on an execution apparatus (115) or is stored on a computer-readable medium.

9. Control apparatus (115) for controlling the population of circuit boards (120) with electronic components (155) by means of a fitting line (110), wherein the control apparatus (115) is configured:

   - to form initially a number of equipment families (250, 255, 320), each with assigned circuit boards (120),
   - wherein an equipment family is defined as a number of circuit boards (120) that can be populated on one fitting line (110) without changing the number of component types that are held ready at the fitting line (110) for populating, wherein a circuit board can can still be taken into an equipment family if the component types of the resulting equipment family can still simultaneously be held ready by supply apparatuses of the fitting line,

   **characterized in that** the control apparatus is further configured:

   - to select one of the equipment families (250, 255, 320)
   - to distribute the circuit boards (120) of the selected equipment family (250, 255, 320) over the other equipment families (250, 255, 320) by means of integer linear programming and
   - to populate the control boards (120) on the respectively assigned fitting lines (110),
   - wherein the distribution comprises the following steps:

      - selection (445) of at least one circuit board (120) of an equipment family (250, 255, 320) other than the one to be distributed;
      - prevention (445) of a change to the existing assignment of the selected circuit board to another equipment family (250, 255, 320), and
      - solution (445) of the remaining problem by means of integer linear programming.

## Revendications

1. Procédé (300) de montage de cartes de circuits imprimés (120) avec des modules électroniques (155) au moyen d'une ligne de montage (110), le procédé comprenant les étapes suivantes:

   - formation initiale (405,435) d'un nombre de groupes d'installation (250, 255, 320) avec des cartes de circuits imprimés associées respectives (120),
   - un groupe d'installation étant déterminé comme étant une quantité de cartes de circuits imprimés (120) qui peuvent être montées sur une ligne de montage (110) sans modifier la quantité des types de module déjà fixés pour le montage sur la ligne de montage (110), une carte de circuits imprimés pouvant alors encore être placée dans un groupe d'installation quand les types de modules du groupe d'installation résultant peuvent être encore simultanément fixés par des dispositifs de rangement de la ligne de montage,

   et **caractérisé par** les étapes suivantes:

   - sélection (440) d'un des groupes d'installation (250, 255, 320);
   - distribution (445) des cartes de circuits imprimés du groupe d'installation (250, 255, 320) sélectionné sur les autres groupes d'installation (250, 255, 320) au moyen d'une programmation linéaire en nombres entiers et
   - montage des cartes de circuits imprimés (120) sur les lignes de montage (110) associées respectives,

   la distribution comprenant les étapes suivantes:

   - sélection (445) d'au moins une carte de circuits imprimés (120) d'un groupe autre que le groupe d'installation (250, 255, 320) à distribuer;
   - interdiction (445) d'une modification de l'association existante de la carte de circuits imprimés sélectionnée vers un autre groupe d'installation (250, 255, 320), et
   - résolution (445) du problème restant à l'aide de la programmation linéaire en nombres entiers.

2. Procédé (300) selon la revendication 1, le groupe d'installation (250, 255, 320) choisi étant celui dont les cartes de circuits imprimés (120) associées présentent le plus petit nombre de types de modules.

3. Procédé (300) selon la revendication 1 ou 2, les groupes d'installation (250, 255, 320) étant sélectionnés et distribués jusqu'à ce que plus aucun groupe d'installation (250, 255, 320) ne puisse être distribué entre les autres groupes d'installation (250, 255, 320).

4. Procédé (300) selon l'une des revendications précédentes, la carte de circuits imprimés (120) étant sélectionnée aléatoirement.

5. Procédé (300) selon l'une des revendications précédentes, la formation initiale d'un groupe d'installation (250, 255, 320) comprenant les étapes suivantes:

- sélection (410) d'une carte de circuits imprimés (120) dont les types de modules associés consomment le plus de piste;
- association (415) de la carte de circuits imprimés (120) sélectionnée à un nouveau groupe d'installation (250, 255, 320);
- sélection (420) d'une des cartes de circuits imprimés (120) restantes, pour laquelle une consommation de piste de l'intersection de leurs types de module avec la quantité des types de module du nouveau groupe d'installation (250, 255, 320) est la plus grande, et
- association (430) de la carte de circuits imprimés (120) sélectionnée au nouveau groupe d'installation (250, 255, 320) dans le cas où (425) la carte de circuits imprimés (120) s'adapte encore au groupe d'installation (250, 255, 320).

6. Procédé (300) selon la revendication 5, d'autres cartes de circuits imprimés (120) étant sélectionnées et associées jusqu'à ce que plus aucune autre carte de circuits imprimés (120) ne s'adapte plus dans le groupe d'installation (250, 255, 320).

7. Procédé (300) selon les revendications 5 ou 6, de nouveaux groupes d'installation (250, 255, 320) se formant et des cartes de circuits imprimés (120) leur étant associées jusqu'à ce que toutes les cartes de circuits imprimés (120) d'un groupe d'installation (250, 255, 320) à monter, soient associées.

8. Produit de programme informatique avec des moyens de codage de programme pour l'exécution du procédé (300) selon l'une des revendications précédentes, quand le produit de programme informatique se déroule sur un dispositif d'exécution (115) ou est mémorisé sur un support pouvant être lu par un ordinateur.

9. Dispositif de commande (115) destiné à commander le montage de cartes de circuits imprimés (120) avec des modules électroniques (155) au moyen d'une ligne de montage (110), le dispositif de commande (115) étant conçu pour:

- former initialement un nombre de groupes d'installation (250, 255, 320) avec respectivement des cartes de circuits imprimés (120) associées,
- un groupe d'installation étant déterminé comme quantité de cartes de circuits imprimés (120) qui peuvent être montées sur une ligne de montage (110), sans modifier la quantité des types de modules déjà fixés pour le montage sur la ligne de montage (110), une carte de circuits imprimés pouvant alors encore être placée dans un groupe d'installation quand les types de modules du groupe d'installation résultant peuvent encore simultanément être fixés par des dispositifs de rangement de la ligne de montage,

**caractérisé en ce que** le dispositif de commande est en outre conçu pour:

- sélectionner un des groupes d'installation (250, 255, 320),
- distribuer (120) les cartes de circuits imprimés (120) du groupe d'installation (250, 255, 320) sélectionné entre les autres groupes d'installation (250, 255, 320) au moyen d'une programmation linéaire en nombres entiers et
- monter les cartes de circuits imprimés (120) sur les lignes de montage (110) respectivement associées,

la distribution comprenant les étapes suivantes:

- sélection (445) d'au moins une carte de circuits imprimés (120) d'un groupe autre que le groupe d'installation (250, 255, 320) à distribuer;
- interdiction (445) d'une modification de l'association existante de la carte de circuits imprimés sélectionnée vers un autre groupe d'installation (250, 255, 320), et
- résolution (445) du problème restant à l'aide de la programmation linéaire en nombres entiers.

# FIG 1

FIG 2

200

220

205

250

250

225

210

255

230

215

260

235

240

265

245

FIG 3

FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009013353 B3
- EP 0478361 A1

- EP 0478360 A1

**In der Beschreibung aufgeführte Nicht-Patentliteratur**

- **DINO LUZZATTO et al.** Cell formation in PCB assembly based on production quantitative data. *European Journal of Operational Research,* 01. September 1993, vol. 69 (3), 312-329